# EUROPEAN PATENT APPLICATION

(11) **EP 3 461 009 A1**
(43) Date of publication of application: **27.03.2019**
(21) Application number: 18195822.4
(22) Date of filing: 20.09.2018
(51) Int. Cl.: H03M 7/40, H04N 19/13, H04N 19/91, H04N 19/98, H03M 7/30, H04N 19/50

(54) **HIGH DENSITY ARCHIVAL**

(30) Priority: 21.09.2017 GB 201715275
(71) Applicant: Codex Digital, London, Greater London W1F 7NT (GB)
(72) Inventor: EGGLETON, James, London, Greater London W1F 7NT (GB); DANDO, Marc, London, Greater London W1F 7NT (GB)
(74) Representative: Nicholls, David Peter

(57) **Abstract**

A computer implemented method of encoding a stream of data samples for lossless compression, the method comprising: receiving a plurality of data samples in a first order; processing the plurality of data samples to provide a plurality of values; classifying the plurality of values into a plurality of sets, wherein at least two of the sets of the plurality of sets are classified using different bit sizes; generating a classifier indicating the set classification of each value of the plurality of values; determining metadata associated with the plurality of sets classified using different bit sizes, wherein the metadata comprises information indicative of the bit size of each of the plurality of values; and encoding at least one set of the plurality of sets, the classifier and metadata, thereby to provide lossless compression of the stream of data samples.

## Description

### Field of the invention

The invention relates to the lossless compression of data. In particular, but not exclusively, the invention relates to encoding and decoding streams of video data.

### Background of the invention

There is a need for efficient data storage at high densities, particularly in industries such as the film industry, where high resolution data is recorded and subsequently played back on large display screens, such as cinema screens. In such cases, in order to preserve the required high resolution for playback on large displays, video data is typically recorded by high-end cinematography cameras at rates of the order of 200 MB/s to 750 MB/s when operating at 24 Hz. For example, recording ARRIRAW 6560 x 3100 12-bit Bayer pattern images at 24 Hz results in a recording rate of 732 MB/s. When recording at such rates, some feature films will capture in excess of 200 hours of footage, the total amount of video data that needs to be stored may be of the order of 500 TB, or more. Other data capture rates may be used, in cinematography, which may slightly increase or decrease the amount of data storage required. For uncompressed capture, required storage is directly proportional to the resolution, bit depth and frequency of recording.

It is known to compress video data such that the required storage space for the video data is reduced, however, such compression is ordinarily lossy. Whilst this reduces bandwidth requirements when processing or transmitting data, lossy compression means that faithful representation of the data on playback, at the resolution recorded, is not possible, since data has been discarded during compression. As a consequence, it is often considered desirable in the film industry to record video data using uncompressed means; this results in a large amount of data being recorded. However, processing large amounts of data, at high rates, requires high processing power and results in inefficiencies, such as the generation of unwanted thermal energy.

Whilst lossless compression is known, available techniques are unable to deal with the rate of data that is recorded in real-time for the purpose of professional high resolution filming. During the course of a day a camera may generate terabytes of data which needs to be encoded. Such encoding is typically complex requiring powerful processors and due to the complexity of the process typically cannot be easily adapted to hardware based implementations. As a result, it is not feasible to record compressed data, without loss, at the point of recording e.g. at a video camera. This means that, in order to distribute compressed data, uncompressed raw data must subsequently be processed, which may take many hours longer than the original filming duration.

It is an aim of the present invention to mitigate for at least some of the above described problems.

In order to mitigate for at least some of the above described problems there is provided a computer implemented method of encoding a stream of data samples for lossless compression, the method comprising: receiving a plurality of data samples in a first order; processing the plurality of data samples to provide a plurality of values; classifying the plurality of values into a plurality of sets, wherein at least two of the sets of the plurality of sets are classified using different bit sizes; generating a classifier indicating the set classification of each value of the plurality of values; determining metadata associated with the plurality of sets classified using different bit sizes, wherein the metadata comprises information indicative of the bit size of each of the plurality of values and encoding at least one set of the plurality of sets, the classifier and metadata, thereby to provide lossless compression of the stream of data. Beneficially, data encoded and recorded in this way requires less storage space, but does not lose data that might otherwise affect the fidelity of video data during playback. Advantageously, such a method is fast and enables real-time encoding of video data.

Optionally, processing the plurality of data samples to provide a plurality of values comprises using a predictor function, preferably wherein the predictor function is used to determine the plurality of values based on temporally earlier and/or spatially local samples of the plurality of data samples.

Optionally, the predictor function is an arithmetic difference function, adapted to: determine the arithmetic difference between each data sample of the plurality of data samples and a reference sample, wherein processing the plurality of data samples to provide a plurality of values comprises determining the difference between each data sample and a reference sample. Advantageously, by providing a sequence of data values that are differences as opposed to absolute values, the data size requirements are typically reduced, since the change in intensity from one pixel to the next is ordinarily less than the absolute value. Further, by transforming differences, which may be positive or negative values, using zigzag encoding, as described below, reduction in data size for the zigzag encoded differences is enabled, as similar negative and positive differences are encoded with similar sized data requirements.

Optionally, each data sample of the plurality of data samples has its own reference sample. Optionally, there is one or more global reference samples. Optionally, the reference sample is the immediate predecessor sample for each data sample.

Optionally, classifying the plurality of values into a plurality of sets comprises reordering the plurality of values. Advantageously, by sorting the differences into a different order, such as an ascending order, the sorted data sample values can be split into two sets of values, which may be described using different size data, as one set of values are smaller than the other set of values (with each set being limited by the largest value in the set).

Optionally, reordering the plurality of values in each of the plurality of sets in accordance with the first order thereby to provide a plurality of reordered sets classified using different bit sizes and wherein the plurality of reordered sets classified using different bit sizes, the classifier and metadata associated with each of the plurality of reordered sets are encoded.

Optionally, reordering the plurality of values comprises applying a sorting function to the plurality of data samples in the first order. Optionally, the sorting function is performed using a sorting network. Advantageously, sorting networks provide excellent performance on small list lengths, thereby enabling fast processing times and facilitating the implementation of lossless compression, for example embedded in video cameras.

Optionally, classifying the plurality of values into a plurality of sets comprises using a histogram binning of the plurality of values.

Optionally, the plurality of sets comprises a high bit set and a low bit set.

Optionally, the plurality of data samples consists of sixteen samples and/or wherein the plurality of sets consists of eight samples. Beneficially, sixteen data samples are processed at a time as this provides efficient byte-sized processing of data sets. Further, beneficially, the use of sixteen data samples in a group enables known optimal sorting networks to be used, thereby to provide efficient sorting.

Optionally, the plurality of sets are encoded using a compact binary encoding of real integer values. Optionally, the compact binary encoding is a Zigzag encoding. Beneficially, this means a reduction in data size for the zigzag encoded differences is enabled, as similar negative and positive differences are encoded with similar sized data requirements. Optionally, the classifier is a bit mask.

Optionally, the stream of data samples represents an ordered list of samples from an image raster. Optionally, each data sample of the plurality of data samples corresponds to a signal at an imaging sensor photosite. Optionally, the plurality of data samples in the first order forms part of a scan line captured at a camera. Optionally, the plurality of data samples in the first order corresponds to a colour channel. Optionally, the plurality of data samples in the first order are odd or even sample sequences.

Optionally, the method comprises transmitting the encoded at least one set of the plurality of sets, classifier and metadata.

In order to mitigate for at least some of the above described problems there is provided an apparatus arranged to perform a method comprising: receiving a plurality of data samples in a first order; processing the plurality of data samples to provide a plurality of values; classifying the plurality of values into a plurality of sets, wherein at least two of the sets of the plurality of sets are classified using different bit sizes; generating a classifier indicating the set classification of each value of the plurality of values; determining metadata associated with the plurality of sets classified using different bit sizes, wherein the metadata comprises information indicative of the bit size of each of the plurality of values and encoding at least one set of the plurality of sets, the classifier and metadata, thereby to provide lossless compression of the stream of data.

Optionally, the apparatus is configured to perform the method in real-time, thereby to record a compressed video data stream. Beneficially, the apparatus is enabled to output compressed data without the burden for compressing data being placed elsewhere, thereby providing a more efficient system. Optionally, the apparatus comprises a video camera. Advantageously, the video camera is enabled to encode data at the point of capture.

In order to mitigate for at least some of the above described problems there is provided a computer program product comprising instructions which, when the program is executed by a computer, cause the computer to carry out perform a method comprising: receiving a plurality of data samples in a first order; processing the plurality of data samples to provide a plurality of values; classifying the plurality of values into a plurality of sets, wherein at least two of the sets of the plurality of sets are classified using different bit sizes; generating a classifier indicating the set classification of each value of the plurality of values; determining metadata associated with the plurality of sets classified using different bit sizes, wherein the metadata comprises information indicative of the bit size of each of the plurality of values and encoding at least one set of the plurality of sets, the classifier and metadata, thereby to provide lossless compression of the stream of data.

In order to mitigate for at least some of the above described problems there is provided a computer readable medium comprising instructions which, when executed by a computer, cause the computer to carry out a method comprising: receiving a plurality of data samples in a first order; processing the plurality of data samples to provide a plurality of values; classifying the plurality of values into a plurality of sets, wherein at least two of the sets of the plurality of sets are classified using different bit sizes; generating a classifier indicating the set classification of each value of the plurality of values; determining metadata associated with the plurality of sets classified using different bit sizes, wherein the metadata comprises information indicative of the bit size of each of the plurality of values and encoding at least one set of the plurality of sets, the classifier and metadata, thereby to provide lossless compression of the stream of data.

In order to mitigate for at least some of the above described problems there is provided a computer implemented method of decoding data, comprising: receiving at least one encoded set of data samples, wherein at least two of the encoded data samples of the at least one encoded set of data samples are encoded using different bit sizes; receiving a classifier indicating the bit size encoding of each data sample in the at least one encoded set of data samples; receiving metadata associated with the at least one encoded set of data samples; and decoding the at least one encoded set of data samples in order to retrieve the data samples in their original order based on the classifier and the metadata.

In order to mitigate for at least some of the above described problems there is provided an apparatus arranged to perform method of decoding data, comprising: receiving at least one encoded set of data samples, wherein at least two of the encoded data samples of the at least one encoded set of data samples are encoded using different bit sizes; receiving a classifier indicating the bit size encoding of each data sample in the at least one encoded set of data samples; receiving metadata associated with the at least one encoded set of data samples; and decoding the at least one encoded set of data samples in order to retrieve the data samples in their original order based on the classifier and the metadata. Advantageously, decoding data encoded as described above is as fast or faster than encoding, thereby reducing the burden on reconstruction of data for playback. Beneficially, such a method of decoding is quickly and efficient, whilst retaining high quality video data, thereby to provide full fidelity/high quality, faithful, playback.

### Description of an embodiment of the invention

A detailed description of an embodiment of the invention will now be described with reference to the figures in which:
Figure 1 is a schematic of an apparatus for recording, encoding and decoding video data in accordance with the invention;
Figure 2A is a process flow for encoding data in accordance with the invention;
Figure 2B is a process flow for encoding data in accordance with the invention;
Figure 2C is a process flow for encoding data in accordance with the invention;
Figure 2D is a process flow for encoding data in accordance with the invention;
Figure 3 is a process flow for decoding data in accordance with the invention;
Figure 4 is a table of exemplary data processed in accordance with the invention;
Figure 5 is a table of exemplary data processed in accordance with the invention;
Figure 6 is a table of exemplary data processed in accordance with the invention;
Figure 7 is a table of exemplary data processed in accordance with the invention; and
Figure 8 is a histogram table of exemplary data processed in accordance with the invention.

Further aspects of the invention will be apparent from the appended description and claims.

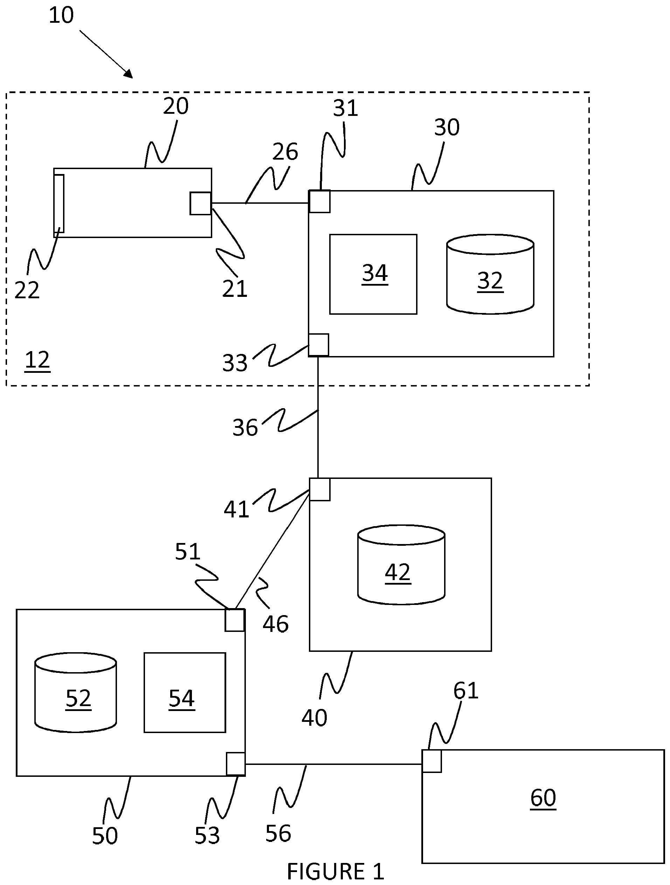

Figure 1 is a schematic of an apparatus 10 for recording, encoding and decoding video data in accordance with the invention. There is shown a recording apparatus 12 having a video camera 20 and a processing unit 30. The video camera has a sensor array 22 and is in communication with the processing unit 30 via communication link 26 created between the interface 21 of the camera 20 and the interface 31 of the processing unit 30. The processing unit 30 has a process of 34 and a memory 32.

The recording apparatus 12 is in communication with a storage apparatus 40 that has a memory 42. The processing unit 30 is in communication with the storage apparatus 40 via a communication link 36 formed between the interface 33 of the processing unit 30 and the interface 41 of the storage apparatus 40. The storage apparatus 40 is shown as a distinct device in Figure 1. Alternatively, or additionally, the storage apparatus 40 forms an integral part of the recording apparatus 12, or is insertable into the recording apparatus 12, e.g., in the form of a cartridge, such as a solid state drive (SSD) cartridge. Alternatively, or additionally, the storage apparatus 40 is a hard disk drive (HDD) or a Linear Tape-Open (LTO) cartridge.

The storage apparatus 40 is also shown in communication with a playback device 50 via communication link 46 between the interface 41 of the storage apparatus 40 and an interface 51 of the playback device 50. The playback device 50 has a processor 54 and a memory 52. The playback device 50 is in communication with a display 60 via communication link 56 between the interface 61 of the display 60 and an interface 53 of the playback device 50. Whilst the display 60 is shown to be separate from the playback device 50, alternatively, or additionally, it forms an integral part of the playback device 50. Whilst the storage device 40 is shown to be distinct from the playback device 50, alternatively, or additionally, the storage device 40 forms an integral part of the playback device 50. The storage device 40 may be a SSD or HDD. Alternatively, or additionally, the storage device 40 is insertable into the playback device 50, e.g., in the form of a cartridge. The storage device 40 may comprise a magnetic tape data storage technology, such as Linear Tape-Open (LTO) technology.

It is known in the prior art to use recording apparatuses, such as the recording apparatus 12 of Figure 1, in order to record and store uncompressed data, for example, at memory 32 or memory 42. In such cases, images captured at the sensor array 22 are processed at the processor 34 or the processor unit 30, such that the raw data can be stored permanently, or temporarily, in the memory 32, or the memory 42. Similarly, the recording apparatus 12 can also be used in order to store data recorded using lossy compression techniques. In such cases, the raw data may be captured at the sensor array 22 and processed at processor 34 of processing unit 30 such that streams of data that are temporarily stored in memory 32 are encoded by the processor 34 of the processing unit 30, prior to being stored in a compressed format at memory 42. Real-time recording of large amounts of data captured at high data rates, in this fashion, can result in certain inefficiencies, such as the production of excess heat energy.

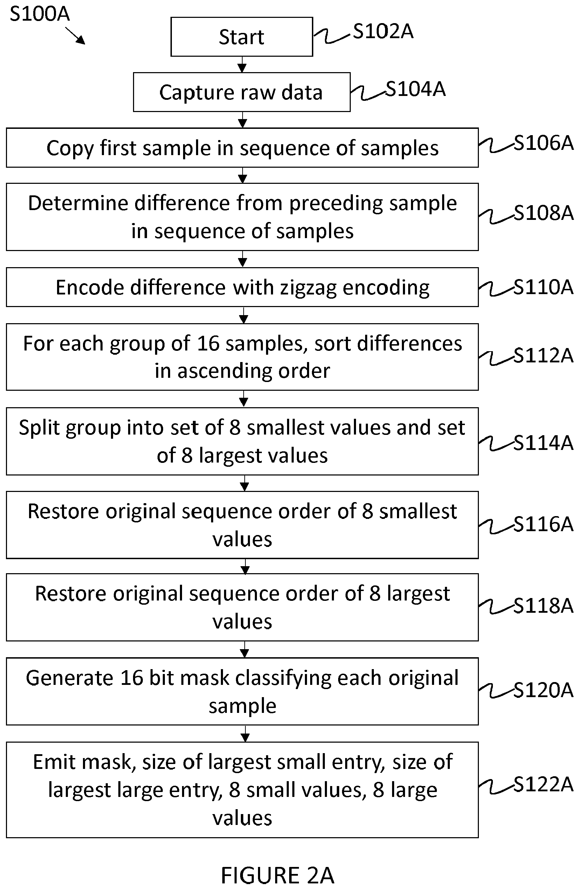

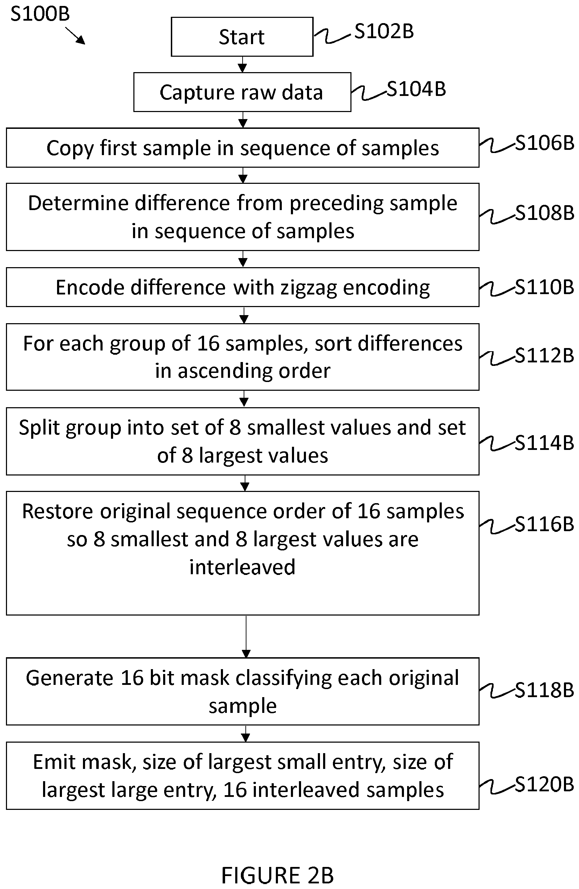

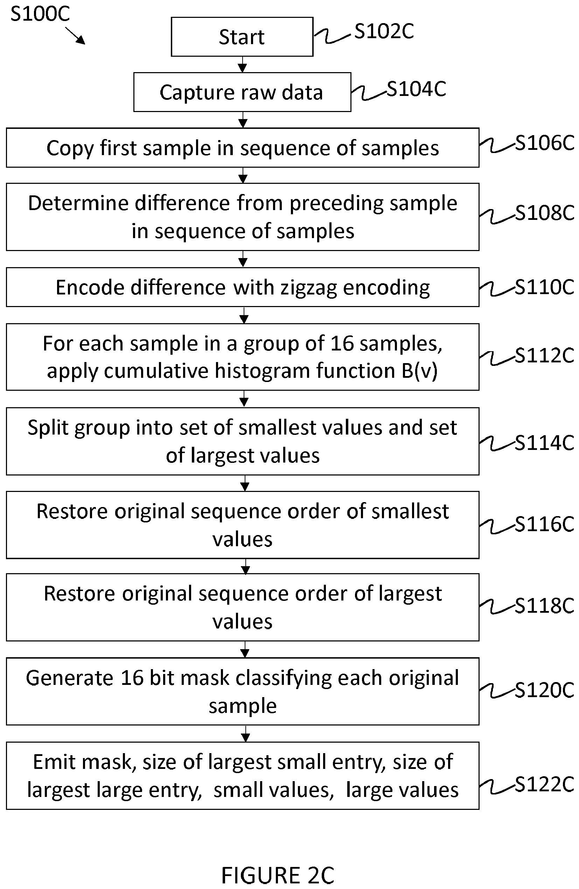

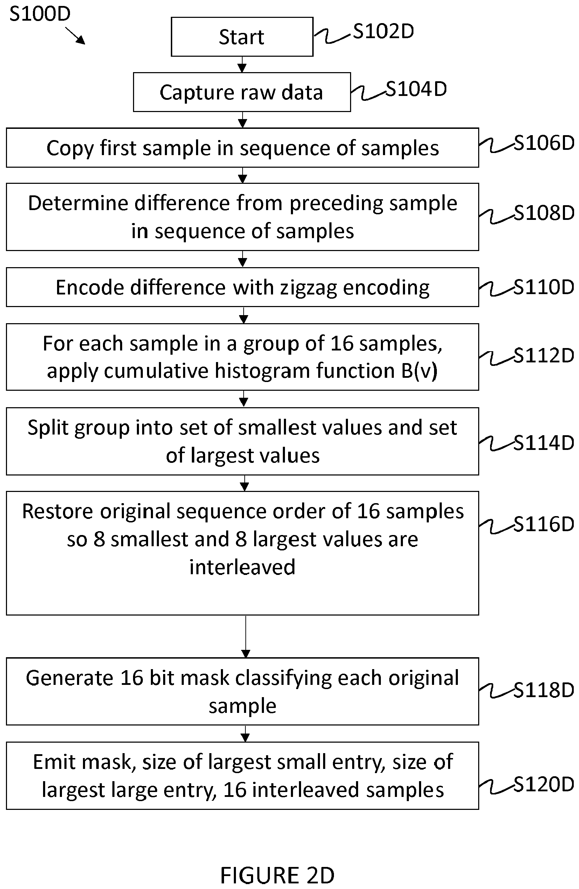

A process for lossless compression will now be described with reference to Figures 2 to 8. Such lossless compression can be implemented at a recording apparatus, such as the recording apparatus 12 of Figure 1. Data that is encoded using the lossless compression technique described with reference to Figures 2 to 8 is played back through a display, such as display 60 that is connected to playback device 50. Beneficially, data encoded and recorded in the way described herein requires less storage space, but does not lose data that might otherwise affect the fidelity of video data during playback. Advantageously, the techniques are fast and enable real-time encoding and decoding of the processed video data.

Whilst the techniques described herein are applicable and advantageous in the lossless compression video data, they are also applicable to lossless compression of data, such as audio data.

Figure 2A is a process flow for encoding data in accordance with the invention. The process S100A commences at step S102A, whereby video data recording is commenced. Video data recording is performed using a video camera, such as video camera 20 of Figure 1.

The process commences by capturing raw data at step S104A, the raw data is captured by the video camera 20 and relayed to the processing unit 30 via communication link 26 between the interface 21 of the video camera 20 and the interface 31 of the processing unit 30. The raw data is temporarily held in the memory 32 of the processing unit 30, whilst it is processed. The raw data captured by the video camera 20 and stored temporally in the memory 32 of the processing unit 30 is dealt with in groups of 16 data samples. The groups of 16 data samples form part of a region, which may be a rectangular region. In an example, the rectangular region is a scan line, which scan line is split by colour channel, making it possible to exploit correlations present within each colour channel. Accordingly, each pixel in a sensor array, such as the sensor array 22 provides a series of data at a sampling rate that provides the necessary amount of information required for video playback. Accordingly, the pixels in the sensor array 22 are imaging sensor photosites that generate signals that are processed by the processing unit 30. The sensor array 22 has a conventional Bayer arrangement and therefore scan lines are divided into odd and even sample sequences to take into account the arrangement of blue and green and red and green pixels. Alternatively, or additionally, scan lines are divided into red, green and blue sample sequences. Alternatively, or additionally, scan lines are divided into sample sequences based on the arrangement of colour pixels in the sensor array 22.

In order to process the group of 16 data samples, the process moves to step S106A, whereby a copy is made of the first sample in the sequence of 16 data samples. The processor 34 processes a copy of the first sample that is made in the memory 32 of the processing unit 30, in order to provide a reference point from which assessment of the data samples can be made. In an embodiment, the group of 16 data samples relates to a delta value relative to a reference sample outside the group. For example, sixteen adjacent pixels outside of the group are chosen (for example to the left and above). The selection of the group of reference pixels may be in any geometry, for example 16x1, 8x2, 4x4, 2x8, 1x16. Other selections of the reference sample may be used. The pixels are imaging sensor photosites that are used to generate signals. Alternatively, or additionally, the group of 16 data samples is any known combination of data samples. Beneficially, 16 data samples are processed at a time as this provides efficient byte-sized processing of data sets. However, additionally, or alternatively, sequences of different numbers of data samples are processed, beneficially bringing different or additional processing benefits. Alternatively, or additionally, each data sample has a reference sample that is its own reference sample, which may be the immediate predecessor sample. Alternatively, or additionally, the reference sample is a global reference sample. A global reference sample may be a reference sample for a group of data samples, for example, the group of 16 data samples. In further examples, the global reference sample is a reference sample for any number of samples. In further examples, the reference sample is a dynamic value that is dynamically updated as an image is processed, thereby enabling efficient and adaptable image processing.

The process then moves to step S108A whereby the difference between the second data sample in the sequence of data samples and the first data sample in the sequence of data samples is determined. For the first data sample in the sequence of data samples, the determined difference may be set at 0, or may be the difference between the first sample in the set of data samples and the previous sample in the previous proceeding set of data samples of a preceding scanline. The difference between each data sample and each proceeding data sample is determined for the entire sequence of 16 data samples in each group of data samples, thereby providing 16 data values. Advantageously, by providing a sequence of data values that are differences as opposed to absolute values, the data size requirements are typically reduced, since the change in intensity from one pixel (i.e., one imaging photosite) to the next is ordinarily less than the absolute value. Further, by transforming differences, which may be positive or negative values, using zigzag encoding, as described below, reduction in data size for the zigzag encoded differences is enabled, as similar negative and positive differences are encoded with similar sized data requirements.

Alternatively, or additionally, the group of 16 data samples is processed using a predictor function. The predictor function generates a predicted sample value for the next data sample in a sequence of data samples. The predicted sample value is based on earlier and/or spatially local samples (for example, the immediately preceding sample and/or a sample generated at a neighbouring photosite in a sensor array, such as sensor array 22. The predicted sample values generated by a predictor function are used to determine the arithmetic difference between actual sample values and predicted sample values for the entire sequence of 16 data samples, as described with respect to step S108A. For example, the predicted samples may be reference samples that are compared with actual data samples in order to generate differences, as described with reference to process flow S100. Alternatively, or additionally, further predictor functions are used in order to generate data sample values for processing using the methods described herein.

The process then moves to step S110A, whereby the processor 34 of the processing unit 30 encodes the sequence of sixteen data values that are temporarily stored in the memory 32 of the processing unit 30. At step S110A of process S100A the differences between each sample in a sequence of data samples and the preceding sample relating to each respective data sample in the sequence of data samples is encoded (i.e., the 16 data values determined at step S108A are encoded at step S110A). The differences are encoded using zigzag encoding (a known form of encoding), which moves the sign bit to the least significant bit using the expression in (val<<1)^(val>>31), pseudocode for 32-bit implementation, and which derives its name from the fact that positive and negative numbers alternate once encoded.

Alternatively, or additionally, where predicted sample values are generated and compared with preceding, actual data samples in the sequence of data samples, the differences determined between the actual data samples and the predicted data samples are encoded as described with respect to step S110A.

The zigzag encoding at step S110A results in the production of a sequence of unsigned integers. The process then moves to step S112A. At step S112A the 16 zigzag encoded differences are sorted into an ascending order. This provides a group of 16 sorted data samples. Advantageously, by sorting the differences into an ascending order, the 16 sorted data sample values can be split into two sets of values, which may be described using different size data, as one set of values are smaller than the other set of values (with each set being limited by the largest value in the set).

The process then moves to step S114A whereby the group of 16 sorted data samples is split into two sets of 8 values. The first set of 8 values correspond to the 8 values of the smallest zigzag encoded differences, and the second set of 8 values correspond to the 8 values of the largest zigzag encoded differences. The sorted data is temporarily held in memory 32 as it is processed by the processor 32 of the processing unit 30.

The process then moves to step S116A. At step S116A the original order of the sequence of the 8 smallest values of zigzag encoded differences is restored in accordance with the original order of data values received in the sequence of 16 data samples received at step S104. The revised order of data values is temporarily held in the memory 32 of the processing unit 30 as it is processed by the processor 32.

The process then moves to step S11A8. At step S118A the original sequence order of the 8 largest values in the sample sequence is restored in accordance with the original order of data values received in the sequence of 16 data samples received at step S104A. The revised order of data values is temporarily held in the memory 32 of the processing unit 30 as it is processed by the processor 32.

Following the process performed at step S116A and at step S118A, two sets of encoded data samples are provided, each with values corresponding to the original sequence of data captured at step S104A, albeit split into smaller values in the first set and large values in the second set. This means that the two sets may be represented using different numbers of bits.

The process then moves to step S120A. At S120A a 16-bit mask is generated by the processor 34 of the processing unit 30. The 16-bit mask classifies each original data sample (i.e., the data representing the difference between values in a sequence of 16 data samples) as belonging to either the small set of data values or the large set of data values. Alternatively, or additionally, any classifier is used to classify the original data sample as belonging to the small set of data values, or the large set of data values. Alternatively, or additionally, a classifier is used to classify the original data sample as belonging to different sets of data values. For example, a small set of data values, a medium set of data values and a large set of data values. Alternatively, or additionally, there may be any number of sets of data values that a classifier may be used to classify. At step S120A, the 16-bit mask that is generated is temporarily held in the memory 34 of the processing unit 30 before being emitted at step S122A.

The process then moves to step S122A, whereby the mask generated at step S120A is emitted by the processing unit 30, along with data indicating the size of the largest small entry, and data indicating the size of the largest large entry, along with the 8 small data sample values that have been encoded using zigzag encoding, and the 8 large sample values which have been encoded using zigzag encoding. In an embodiment, the data is stored in the following order:
(1) the data indicating the size of the largest small entry and the size of the largest large entry [s0s1] -, (2) the classifier [mask], (3) the smallest eight values [small8], (4) and the largest 8 values [large8]. By following the set order, consistency in encoding and decoding may occur. In further embodiments, the order in which the data is stored may change. The data emitted at step S122A is compressed with respect to the raw data captured at step S104A and provides all necessary information for the data to be decoded without loss of the original raw data. The data is emitted from the processing unit 30 to the storage apparatus 40, where the data is stored in the memory 42 of the storage apparatus 40. The meta-data indicating the size of the largest small entry and the meta-data indicating the size of the largest large entry are determined when the group of ascending order, zigzag encoded difference values is split into two groups at step S114A of the process S100A. Alternatively, or additionally, the meta-data indicating the size of the largest small entry and the meta-data indicating the size of the largest large entry are determined at any appropriate juncture in the process S100 and emitted with the data sets at step S122A.

Whilst the process flow S100A is described as emitting the mask, meta-data and data at step S122A, alternatively, or additionally, further information is also emitted that enables the compressed video data to be searched in an efficient manner. Alternatively, or additionally, the data that is emitted at step S122A is emitted in a format that enables efficient processing of the data as part of a data message.

The process flow S100A is described in respect of real-time processing of data at the processing unit 30. Advantageously, such real-time processing enables the technique of encoding video data to provide lossless compression to be implemented at a video camera prior to further distribution. Even in the event that high complexity images are recorded, which require the first set and second set to be described with a high number of bits, the accumulation of compression over the length of the video still provides significant data compression, thereby reducing storage requirements, as well as providing more efficient processing of recorded data (resulting in a reduction of time and improved energy conservation (e.g., by reducing heat generation).

Whilst the process flow S100A is described in respect of splitting the group of 16 samples into two sets of 8 samples and restoring the order of the samples in each group in accordance with the original sequence of data samples (a first set corresponding to the 8 smallest values and a second set corresponding to the 8 largest values), alternatively, or additionally, the 16 values are restored into a set of 16 values once each value has been classified as belonging to the smallest or largest group of values. Consequently, at step S122A, the 8 small values and the 8 large values are emitted in a single set of reordered values, reordered in accordance with the original sequence of data samples. The small values and the large values are interleaved in accordance with the original sequence of data samples.

For example, in the event that a sequence of data samples is processed such that the classification is given as: 0110 0010 1101 1001, where 0 indicates a small value, and 1 indicates a large value, in one example each class of differential value (i.e. small or large) is emitted in a continuous run. This has the effect of 'shuffling' the original sample order (e.g., {bit size metadata} {classifier/mask} {S0, S1, S2, S3, S4, S5, S6, S7} {L0, L1, L2, L3, L4, L5, L6, L7} - separated into a small set and a large set). Encoding and decoding in such a manner is straightforward, particularly when Small and Large sets are multiples of 8. The multiple of 8 ensures that each run of values exactly fits within byte boundaries. The encode/decode loops may be heavily optimised.

In a further example, in the event that a sequence of data samples is processed such that the classification is given as: 0110 0010 1101 1001, where 0 indicates a small value, and 1 indicates a large value, in one example each class of differential value (i.e. small or large) is emitted in the order they appeared in the source image. (e.g., {bit size metadata} {classifier/mask} {S0, L0, L1, S1, S2, S3, L2, S4, L3, L4, S5, L5, L6, S6, S7, L7} - interleaved small and large).

Whilst the above process S100A is described in respect of real-time processing of data, alternatively or additionally, the data captured by the video camera 20 is stored in uncompressed format and subsequently processed at a processing unit that is not part of the video camera 30. Advantageously, whilst one copy of the uncompressed data is recorded using the video camera 20, the burden for processing the data is moved to the processing unit that is used to encode the data. The encoded data is advantageously compressed for distribution and decoding at multiple end points, as required.

Whilst process flow S100A is described with respect to processing 16 data samples in a sequence, alternatively, or additionally, data sample sequences with different numbers of data samples are used to provide compressed data.

Whilst the differences in data are described as being encoded using zigzag encoding, alternatively, or additionally, different encoding algorithms are used. For example, any type of compact binary encoding of real integer values may be used. Alternatively, or additionally, no encoding of the differences is used at step S108A. Further, additionally, or alternatively, raw data is divided into two or more sets without determining the differences in values between samples at step S106A. In the event that sets of data are described with different bit sizes, there is some compression of data. This may be beneficial when compression is sought without introducing further overhead. However, further benefits are brought through the use of the assessment of differences between data samples, as opposed to absolute values.

Whilst the mask generated at step S120A has 16 bits, alternatively, or additionally, the bit mask has the same number of bits as data samples in a sequence of data that is being processed. If the number of high bits is constrained by an implementation, then it may be sufficient to encode only (n-1) of n bits, since the n^{th} bit value is implicit in the representation. In the event that there is no storage benefit for a group of 16 samples, the mask is optionally omitted and the 16 samples are emitted in their original order. Whilst the data sample described with respect to process flow S100A has 16 data samples, alternatively, or additionally, there are any number of data samples in a sequence. Further, there is no limit to the number of sequences that are processed in order to encode a particular piece of video data, such as a film. As described above, a mask is a type of classifier. Alternatively, or additionally, any classifier is used to classify the original data sample as belonging to the small set of data values, or the large set of data values. Alternatively, or additionally, a classifier is used to classify the original data sample as belonging to different sets of data values. For example, a small set of data values, a medium set of data values and a large set of data values. Alternatively, or additionally, there may be any number of sets of data values that a classifier may be used to classify.

The process flow S100A is performed such that only two lines are held in the memory 32 of the processing unit 30 at any one time. However, alternatively, or additionally, fewer or more lines are held in the memory 32 of the processing unit 30 at one time.

The sorting operations performed in process flow S100A are performed using sorting networks. Advantageously, sorting networks provide excellent performance on small list lengths, thereby enabling fast processing times and facilitating the implementation of lossless compression, for example embedded in video cameras.

Advantageously, sorting operations are implemented in such a way that CPU/GPU predictive branching is not necessary, which means the timing is more deterministic and few CPU cycles are wasted. This property is especially useful in hardware (FPGA/ASIC) implementations of an algorithm.

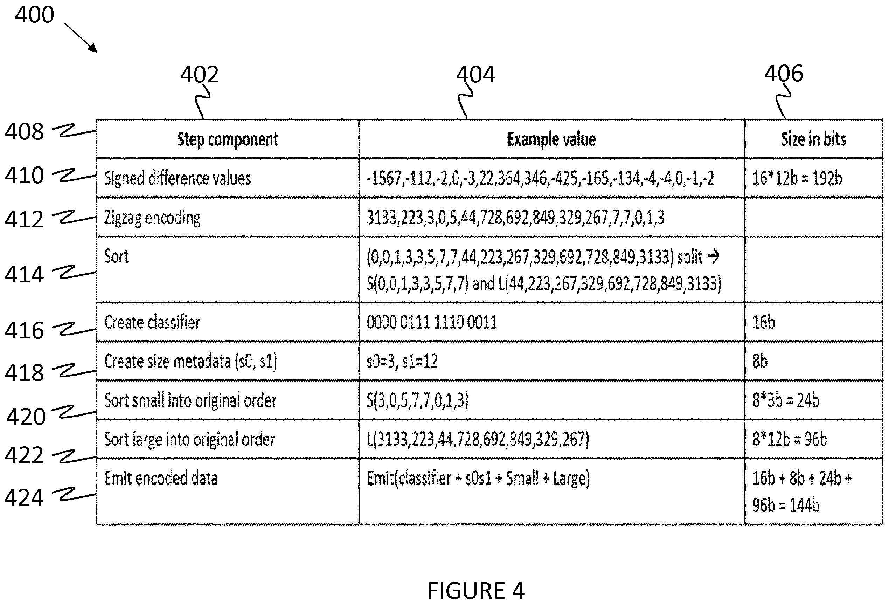

Whilst the process flow S100A describes the classification of data into two groups using sorting operations, alternatively, or additionally, the data values are split into two or more groups using cumulative histograms (as described below with reference to Figures 4C, 4D, 6, 7 and 8). Using such an approach, steps S102A to S110A of process flow S100A are performed and then a histogram of required sample sizes is made. For example, the sample size in bits required for the small set of 8 values is calculated by starting in the lowest histogram bin of how samples might be minimally encoded and adding the frequency in that bin to an accumulator, stopping at the bin that contains the eighth sample. For example, if a list of 16 data samples is described with 5x2-bit samples, 2x3-bit samples, 7x4-bit samples, 1x5-bit sample and 1x10-bit sample, it is evident on inspection that the large set requires 10-bit samples and the small set requires 4-bit samples. This is because 3-bits can only be used to describe 7 samples, whereas 4-bits can be used to describe 14 samples. In essence, the first histogram bin (i.e., sample size) where the cumulative frequency is less than or equal to 8 is sought.

Alternatively, or additionally, other methods to classify data into two or more groups are used.

Figure 2B is a process flow for encoding data in accordance with the invention. The process S100B of Figure 2B outputs the data in a different manner to the process S100A of Figure 2A, however, there are common features. The process S100B commences at step S102B, whereby video data recording is commenced. Video data recording is performed using a video camera, such as video camera 20 of Figure 1. Steps S102B to S114B of process S100B correspond to the steps S102A to S114A of process S100A.

The process then moves to step S116B. At step S116B the original order of the sequence of the 16 values of zigzag encoded differences is restored in accordance with the original order of data values received in the sequence of 16 data samples received at step S104. The revised order of data values is temporarily held in the memory 32 of the processing unit 30 as it is processed by the processor 32.

Following the process performed at step S116B a list of encoded data samples is provided, each with values corresponding to the original sequence of data captured at step S104B. This means different values in the list are represented using different numbers of bits. The 8 smallest values and the 8 largest values as determined at step S114B are interleaved. The process then moves to step S118B.

At S118B a 16-bit mask is generated by the processor 34 of the processing unit 30. The 16-bit mask classifies each original data sample as belonging to either the small set of data values or the large set of data values. Alternatively, or additionally, any classifier is used to classify the original data sample as belonging to the small set of data values, or the large set of data values. Alternatively, or additionally, a classifier is used to classify the original data sample as belonging to different sets of data values. For example, a small set of data values, a medium set of data values and a large set of data values. Alternatively, or additionally, there may be any number of sets of data values that a classifier may be used to classify. At step S118B, the 16-bit mask that is generated is temporarily held in the memory 34 of the processing unit 30 before being emitted at step S120B.

The process then moves to step S120B, whereby the mask generated at step S118B is emitted by the processing unit 30, along with data indicating the size of the largest small entry, and data indicating the size of the largest large entry, along with the 16 data sample values that have been encoded using zigzag encoding.

Figure 2C is a process flow for encoding data in accordance with the invention. The process S100C commences at step S102C, whereby video data recording is commenced. Video data recording is performed using a video camera, such as video camera 20 of Figure 1. Steps S102C to S110C of process S100C correspond to the steps S102A to S110A of process S100A.

At step S112C of process S100C, for each sample in the group of 16 samples determined at step S110C, a cumulative histogram function B(v) is applied. The cumulative histogram function bins the values in order to calculate the number of bits to encode each value as an unsigned integer. A histogram is provided, with the frequency of the bit size being cumulatively assessed in order to determine a splitting point for the histogram.

Once the process has provided a histogram at step S112C, the process S100C moves to step S114C where the values that have been placed in the histogram using the cumulative histogram function B(v) are split into two groups. The split point that is used to split the values into two groups is determined by the preferred size of the small and large sets. For a group of 16 values, if 8 values in each group is required, a threshold of 8 is set and the cumulative frequency bins are sequentially assessed until the first bin that takes the cumulative total of samples to equal or greater than the threshold. Once the 16 values have been split into two sets, the bit size of the largest value in each set is determined.

The process then moves to step S116C. At step S116C the original order of the sequence of the 8 smallest values of zigzag encoded differences is restored in accordance with the original order of data values received in the sequence of 16 data samples received at step S104C. The revised order of data values is temporarily held in the memory 32 of the processing unit 30 as it is processed by the processor 32.

The process then moves to step S118C. At step S118C the original sequence order of the 8 largest values in the sample sequence is restored in accordance with the original order of data values received in the sequence of 16 data samples received at step S104C. The revised order of data values is temporarily held in the memory 32 of the processing unit 30 as it is processed by the processor 32.

Following the process performed at step S116C and at step S118C, two sets of encoded data samples are provided, each with values corresponding to the original sequence of data captured at step S104C, albeit split into smaller values in the first set and large values in the second set. This means that the two sets may be represented using different numbers of bits. The process S100C then moves to step S118C.

At S120C a 16-bit mask is generated by the processor 34 of the processing unit 30. The 16-bit mask classifies each original data sample (i.e., the data representing the difference between values in a sequence of 16 data samples) as belonging to either the small set of data values or the large set of data values. Alternatively, or additionally, any classifier is used to classify the original data sample as belonging to the small set of data values, or the large set of data values. Alternatively, or additionally, a classifier is used to classify the original data sample as belonging to different sets of data values. For example, a small set of data values, a medium set of data values and a large set of data values. Alternatively, or additionally, there may be any number of sets of data values that a classifier may be used to classify. At step S120C, the 16-bit mask that is generated is temporarily held in the memory 34 of the processing unit 30 before being emitted at step S122C.

The process then moves to step S122C, whereby the mask generated at step S122C is emitted by the processing unit 30, along with data indicating the size of the largest small entry, and data indicating the size of the largest large entry, along with the 16 data sample values that have been encoded using zigzag encoding.

Figure 2D is a process flow for encoding data in accordance with the invention. The process S100D commences at step S102D, whereby video data recording is commenced. Video data recording is performed using a video camera, such as video camera 20 of Figure 1. Steps S102D to S110D of process S100D correspond to the steps S102A to S110A of process S100A.

At step S112D of process S100D, for each sample in the group of 16 samples determined at step S110D, a cumulative histogram function B(v) is applied. The cumulative histogram function bins the values in order to calculate the number of bits to encode each value as an unsigned integer. A histogram is provided, with the frequency of the bit size being cumulatively assessed in order to determine a splitting point for the histogram.

Once the process has provided a histogram at step S112D, the process S100D moves to step S114D where the values that have been placed in the histogram using the cumulative histogram function B(v) are split into two groups. The split point that is used to split the values into two groups is determined by the preferred size of the small and large sets. For a group of 16 values, if 8 values in each group is required, a threshold of 8 is set and the cumulative frequency bins are sequentially assessed until the first bin that takes the cumulative total of samples to equal or greater than the threshold. Once the 16 values have been split into two sets, the bit size of the largest value in each set is determined.

The process then moves to step S116D. At step S116D the original order of the sequence of the 16 values of zigzag encoded differences is restored in accordance with the original order of data values received in the sequence of 16 data samples received at step S104D. The revised order of data values is temporarily held in the memory 32 of the processing unit 30 as it is processed by the processor 32.

Following the process performed at step S116D a list of encoded data samples is provided, each with values corresponding to the original sequence of data captured at step S104D. This means different values in the list are represented using different numbers of bits. The 8 smallest values and the 8 largest values as determined at step S114D are interleaved. The process then moves to step S118D.

At S118D a 16-bit mask is generated by the processor 34 of the processing unit 30. The 16-bit mask classifies each original data sample (i.e., the data representing the difference between values in a sequence of 16 data samples) as belonging to either the small set of data values or the large set of data values. Alternatively, or additionally, any classifier is used to classify the original data sample as belonging to the small set of data values, or the large set of data values. Alternatively, or additionally, a classifier is used to classify the original data sample as belonging to different sets of data values. For example, a small set of data values, a medium set of data values and a large set of data values. Alternatively, or additionally, there may be any number of sets of data values that a classifier may be used to classify. At step S118D, the 16-bit mask that is generated is temporarily held in the memory 34 of the processing unit 30 before being emitted at step S120D.

The process then moves to step S120D, whereby the mask generated at step S1118D is emitted by the processing unit 30, along with data indicating the size of the largest small entry, and data indicating the size of the largest large entry, along with the 16 data sample values that have been encoded using zigzag encoding.

The application of process S100A results in the same output at S122A as the application of process S100C at step S122C. The application of process S100B results in the same output at step S120B as the application of process S100D at step S120D. The process flows S100B, S100C and S100D described with respect to Figures 2B, 2C and 2D, respectively, may be alternatively or additionally altered in line with the above described options detailed with respect to S100A of Figure 2A.

Whilst lossless compression is described with different implementations with reference to Figures 2A to 2D and with worked examples in respect of Figures 4 to 8, there are common features of the implementations of encoding a stream of data samples for lossless compression of receiving a plurality of data samples in a first order, processing the plurality of data samples to provide a plurality of values, classifying the plurality of values into a plurality of sets, wherein at least two of the sets of the plurality of sets are classified using different bit sizes, generating a classifier indicating the set classification of each value of the plurality of values, determining metadata associated with the plurality of sets classified using different bit sizes, wherein the metadata comprises information indicative of the bit size of each of the plurality of values, and encoding at least one set of the plurality of sets, the classifier and metadata, thereby to provide lossless compression of the stream of data samples. Whilst specific embodiments are described in detail herein, the inventive principles are not limited to the specific embodiments and further modification and variation is contemplated within the inventive principles that are described.

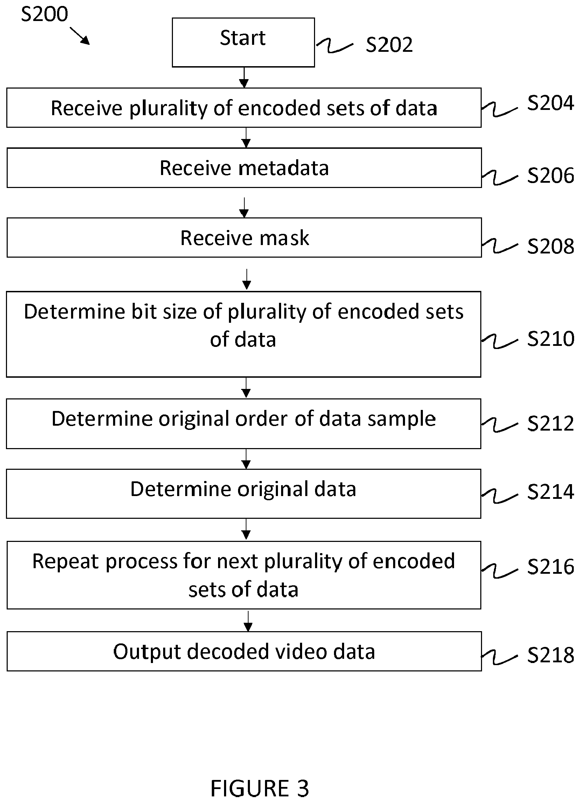

Figure 3 is a process flow S200 for decoding compressed data, in accordance with the invention. The process commences at step S202. The process flow S200 is implemented at a device for playing video data, such as playback device 50, described with reference to Figure 1, above.

At step S204, encoded data is received at the device for playing video data, such as the playback device 50, described with reference to Figure 1. The video data is received via a communication link 46 formed between an interface 41 of a storage apparatus 40 and an interface 51 of the playback device 50. The communication link 46 is formed by inserting a cartridge comprising the storage apparatus 40 into the playback device 50. Alternatively, or additionally, the playback device 50 is configured to receive the data from a storage apparatus 40 in any suitable manner, e.g., streamed data from a central storage apparatus 40.

The data that is received at the playback device 50 is previously encoded as described above, in respect of any of process flow S100A, S100B, S100C and S100D. In addition to receiving the encoded data (for example the data produced by the performance of steps S116A and S118A, described above in relation to Figure 2A), at step S206 metadata describing the size of the encoded data received at step S204 is received and at step S208 a mask is received. Alternatively, or additionally, any classifier is received, whereby the classifier is used to classify the original data sample as belonging to the small set of data values, or the large set of data values. Alternatively, or additionally, a classifier is used to classify the original data sample as belonging to different sets of data values. For example, a small set of data values, a medium set of data values and a large set of data values. Alternatively, or additionally, there may be any number of sets of data values that a classifier may be used to classify. The process moves to step S210.

At step S210 the bit size of the plurality of encoded sets of data is determined at the processor 52 of the playback device 50. This enables the encoded data to be understood in terms of a set of values.

At step S212 the original order of the data samples is determined at the processor 52 of the playback device 50, based on the mask received at step S206.

At step S214, based on the order described by the mask received at step S206 and determined at step S212, the original 16 data samples in respect of the raw data values captured at step S104 of process flow S100 are determined at the processor 52 of the playback device 50, thereby providing a list of 16 data samples that represent the difference between the preceding data value and the current data value. Using a starting value, the original data can be restored. The data received at the playback device 50 is processed in batches temporarily stored at the memory 52 of the playback device 50.

Once one sample has been decoded, the process is repeated for the next plurality of encoded sets of data, as described at step S216 of process flow S200. The decoded video data is output by the playback device 50 at step S218. The decoded video data is viewed at a display 60. Whilst the video output is shown to occur at step S218, following the step of repeated decoding of video data at step S216, alternatively, or additionally, the video data is output at the stage each set of data samples is decoded, therefore to provide real-time decoding and video playback of data.

Advantageously, for data encoded in the manner described with reference to Figures 2A to 2D, decoding is as fast or faster than encoding, thereby reducing the burden on reconstruction of data for playback. This asymmetric process, which is already fast in respect of the encoding speed, is used quickly and efficiently to decode data whilst retaining high quality video data, thereby to provide high quality faithful playback.

A worked example of encoding of raw data is shown at Figure 4. Figure 4 is a table 400 illustrating the component stages 402 of video data compression in terms of exemplary real values 404. The illustrative sample set shows unusually high variance. The corresponding size 406, in bits, of the data is shown at the third column 406 of the table 400. The first row of headers 408 describes the content of the columns 402, 404, 406 of the table 400. The first column lists the component stages 402 of video data compression. The second column shows the values 404 of the data samples as they are processed at various stages of the data encoding.

As described above with reference to the process flow S100A, raw data is captured and processed in batches of 16 data samples. The difference between each data sample in the sequence of 16 data samples is made at step S108A of process flow S100A. This provides a sequence of 16 numbers. An example of such 16 number values is shown at the second row 410, second column 404 of the table 400. These values are: -1567, - 112, -2, 0, -3, 22, 364, 346, -425, -165, -134, -4, -4, 0, -1, -2. Each of the values can be described using 12 bits, hence the total size of this data for 16 samples is 192 bits, as described at the second row 410, third column 406 of the table 400.

These values are then encoded using zigzag encoding, as described at step S110A of process flow S100A. Using this method and applying it to the values of the second row 410 of the second column 404 of the table 400, the following values are produced: 3133, 223, 3, 0, 5, 44, 728, 692, 849, 329, 267, 7, 7, 0, 1, 3. These values are shown at the second column 404 of the third row 412 of the table 400.

Once zigzag encoded, the values are sorted into ascending order and split into two sets, as per steps S112A and S114A of process flow S100A. In ascending order of values of encoded differences, the values are: 0, 0, 1, 3, 3, 5, 7, 7, 44, 223, 267, 329, 692, 728, 849, 3133. Splitting this list into two sets provides a first set of samples of: (0, 0, 1, 3, 3, 5, 7, 7) and a second set of samples of: (44, 223, 267, 329, 692, 728, 849, 3133). This is illustrated at the fourth row 414 of the second column 404 of the table 400.

A classifier is also generated as per step S120A of the flow process S100A. The classifier is a mask that is used to classify the originally determined differences of the received data samples as belonging to the smaller set of eight samples, or the large set of eight samples. In this case, 0 represents the smaller set and 1 represents the larger set. Hence the mask 0x07e3 (=0000 0111 1110 0011) is generated, thereby enabling classification of the data differences shown at the second row 410 of the second column 404 of the table 400 into the smaller or larger set. The mask is 16 bits in size, as described at the third column 406 of the fifth row 416 of the table 400. As described above, alternatively, or additionally, any classifier is used to classify the original data sample as belonging to the small set of data values, or the large set of data values. Alternatively, or additionally, a classifier is used to classify the original data sample as belonging to different sets of data values. For example, a small set of data values, a medium set of data values and a large set of data values. Alternatively, or additionally, there may be any number of sets of data values that a classifier may be used to classify.

Since the first set of sorted, encoded differences can be described using 3 bits, this information is recorded as metadata along with the information that the second set of sorted encoded differences can be described using 12 bits. This is shown at the sixth row 418 of the table 400. This metadata, in an embodiment, is encoded as 0x48 and takes a total of 8 bits to describe, as shown at the third column 406 of the sixth row 418. The metadata may be encoded in other ways known in the art.

The sorted and split data values are then restored to the original order of the sequence of data samples received in the raw data, as per steps S116A and S118A of process flow S100A. This results in a first set of samples as described at the seventh row 420 of the table 400 and a second set of samples as described at the eighth row 422 of the table 400. Therefore, there is a set of the smallest eight values in the order: 3, 0, 5, 7, 7, 0, 1, 3, as described at the second column 404 of the seventh row 420, which has a size of 8 multiplied by 3 bits (24 bits - as described at the third column 406 of the seventh row 420), since the values of data can be described using 3 bits, as this is permits the largest value of the set to be recorded.

There is also a set of the largest eight values in the order: 3133, 233, 44, 728, 692, 849, 329, 267, as described at the second column 404 of the eighth row 422, which has a size of 8 multiplied by 12 bits (96 bits - as described at the third column 406 of the eighth row 422), since the values of data can be described using 12 bits, as this permits the largest value of the set to be recorded.

In line with step S122A of the process flow S100A, the data that is emitted is shown at the ninth row 424 of the second column 404 of the table 400. The encoded data includes the mask, the metadata and the two sets of re-ordered data and hence has a size of 16 bits for the mask, 8 bits for the metadata, 24 bits for the small set of data and 96 bits for the large set of data. In total, the size of the compressed, encoded data is 144 bits. This is smaller than the original 192 bits determined in respect of the differences between samples of data in a sequence of 16 data samples, but contains enough information for the original data to be decoded. Therefore, in this case, the data stored, once compressed is 75% of the original data size. Whilst compression is described with respect to a particular data set at Figure 4, the process is applicable to different sets of data.

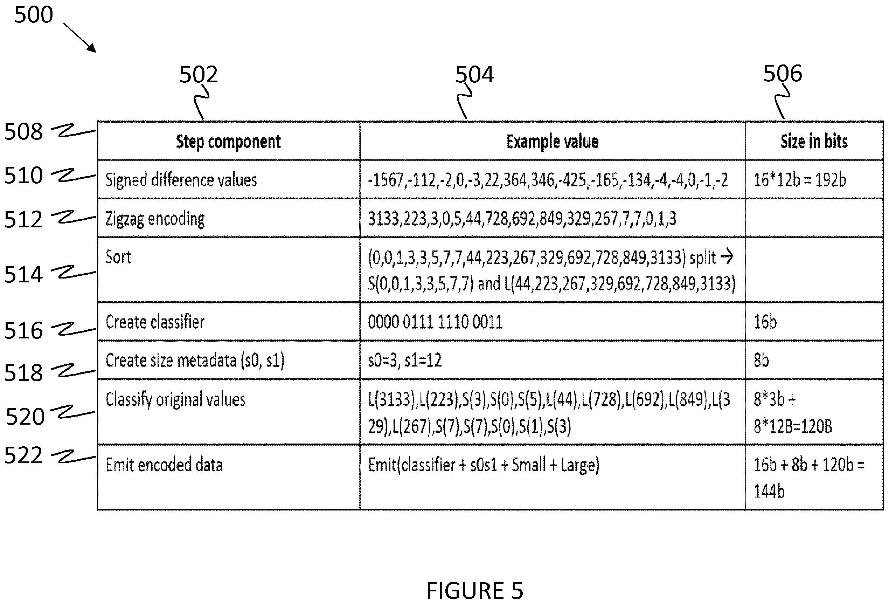

A further worked example of encoding of raw data is shown at Figure 5. Figure 5 is a table 500 illustrating the component stages 502 of video data compression in terms of exemplary real values 504. The illustrative sample set shows unusually high variance. The corresponding size 506, in bits, of the data is shown at the third column 506 of the table 500. The first row of headers 508 describes the content of the columns 502, 504, 506 of the table 500. The first column lists the component stages 502 of video data compression. The second column shows the values 504 of the data samples as they are processed at various stages of the data encoding.

As described above with reference to the process flow S100B, raw data is captured and processed in batches of 16 data samples. The difference between each data sample in the sequence of 16 data samples is made at step S108B of process flow S100B. This provides a sequence of 16 numbers. An example of such 16 number values is shown at the second row 510, second column 504 of the table 500. These values are: -1567, - 112, -2, 0, -3, 22, 364, 346, -425, -165, -134, -4, -4, 0, -1, -2. Each of the values can be described using 12 bits, hence the total size of this data for 16 samples is 192 bits, as described at the second row 510, third column 506 of the table 500.

These values are then encoded using zigzag encoding, as described at step S110B of process flow S100B. Using this method and applying it to the values of the second row 510 of the second column 504 of the table 500, the following values are produced: 3133, 223, 3, 0, 5, 44, 728, 692, 849, 329, 267, 7, 7, 0, 1, 3. These values are shown at the second column 504 of the third row 512 of the table 500.

Once zigzag encoded, the values are sorted into ascending order and split into two sets, as per steps S112B and S114B of process flow S100A. In ascending order of values of encoded differences, the values are: 0, 0, 1, 3, 3, 5, 7, 7, 44, 223, 267, 329, 692, 728, 849, 3133. Splitting this list into two sets provides a first set of samples of: (0, 0, 1, 3, 3, 5, 7, 7) and a second set of samples of: (44, 223, 267, 329, 692, 728, 849, 3133). This is illustrated at the fourth row 514 of the second column 504 of the table 500.

A classifier is also generated as per step S120B of the flow process S100B. The classifier is a mask that is used to classify the originally determined differences of the received data samples as belonging to the smaller set of eight samples, or the large set of eight samples. In this case, 0 represents the smaller set and 1 represents the larger set. Hence the mask 0x07e3 (=0000 0111 1110 0011) is generated, thereby enabling classification of the data differences shown at the second row 510 of the second column 504 of the table 500 into the smaller or larger set. The mask is 16 bits in size, as described at the third column 506 of the fifth row 516 of the table 500. As described above, alternatively, or additionally, any classifier is used to classify the original data sample as belonging to the small set of data values, or the large set of data values. Alternatively, or additionally, a classifier is used to classify the original data sample as belonging to different sets of data values. For example, a small set of data values, a medium set of data values and a large set of data values. Alternatively, or additionally, there may be any number of sets of data values that a classifier may be used to classify.

Since the first set of sorted, encoded differences can be described using 3 bits, this information is recorded as metadata along with the information that the second set of sorted encoded differences can be described using 12 bits. This is shown at the sixth row 518 of the table 500. This metadata, in an embodiment, is encoded as 0x48 and takes a total of 8 bits to describe, as shown at the third column 506 of the sixth row 518. The metadata may be encoded in other ways known in the art.

The sorted and split data values are then restored to the original order of the sequence of data samples received in the raw data, as per steps S116B of process flow S100B. This results in a set of samples as described at the seventh row 520 of the table 500. Therefore, there is an interleaved set of the sixteen large and small values in the order: 3133,223,3,0,5,44,728,692,849,329,267,7,7,0,1,3, as described at the second column 504 of the seventh row 520, which has a size of 8 multiplied by 3 bits plus 8 multiplied by 12 bits (120 bits, as described at the third column 506 of the seventh row 520). Since the small values of data can be described using 3 bits, this is permits the largest value of the small values to be recorded and since the large values of data can be described using 12 bits, this permits the largest value of the large set to be recorded.

In line with step S120B of the process flow S100B, the data that is emitted is shown at the eighth row 522 of the second column 504 of the table 500. The encoded data includes the mask, the metadata and the interleaved small and large values and hence has a size of 16 bits for the mask, 8 bits for the metadata, 120 bits for the interleaved small and large values of data. In total, the size of the compressed, encoded data is 144 bits. This is smaller than the original 192 bits determined in respect of the differences between samples of data in a sequence of 16 data samples, but contains enough information for the original data to be decoded. Therefore, in this case, the data stored, once compressed is 75% of the original data size. Whilst compression is described with respect to a particular data set at Figure 5, the process is applicable to different sets of data.

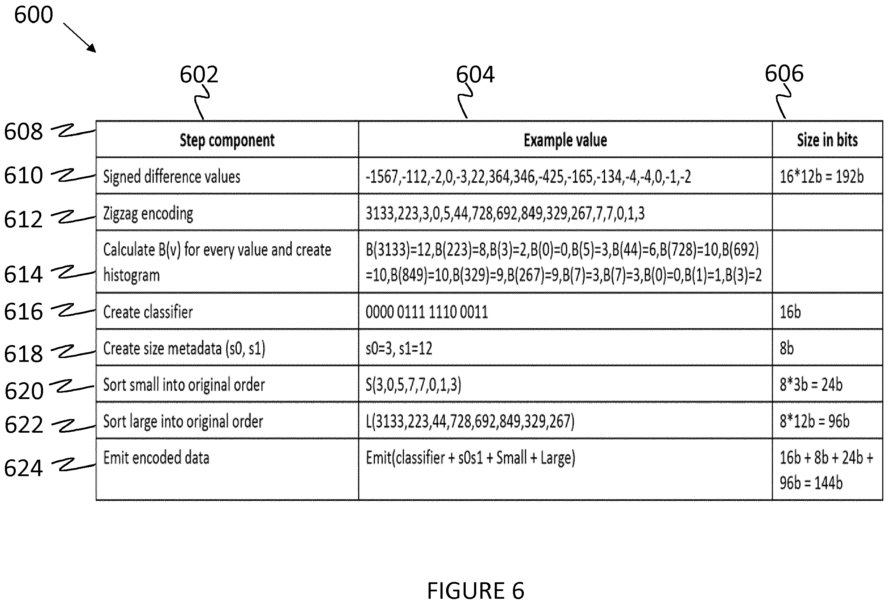

A further worked example of encoding of raw data is shown at Figure 6. Figure 6 is a table 600 illustrating the component stages 602 of video data compression in terms of exemplary real values 604. The illustrative sample set shows unusually high variance. The corresponding size 606, in bits, of the data is shown at the third column 606 of the table 600. The first row of headers 608 describes the content of the columns 602, 604, 606 of the table 600. The first column lists the component stages 602 of video data compression. The second column shows the values 604 of the data samples as they are processed at various stages of the data encoding.

As described above with reference to the process flow S100C, raw data is captured and processed in batches of 16 data samples. The difference between each data sample in the sequence of 16 data samples is made at step S108C of process flow S100C. This provides a sequence of 16 numbers. An example of such 16 number values is shown at the second row 610, second column 604 of the table 600. These values are: -1567, - 112, -2, 0, -3, 22, 364, 346, -425, -165, -134, -4, -4, 0, -1, -2. Each of the values can be described using 12 bits, hence the total size of this data for 16 samples is 192 bits, as described at the second row 610, third column 606 of the table 600.

These values are then encoded using zigzag encoding, as described at step S110C of process flow S100C. Using this method and applying it to the values of the second row 610 of the second column 604 of the table 600, the following values are produced: 3133, 223, 3, 0, 5, 44, 728, 692, 849, 329, 267, 7, 7, 0, 1, 3. These values are shown at the second column 604 of the third row 612 of the table 600.

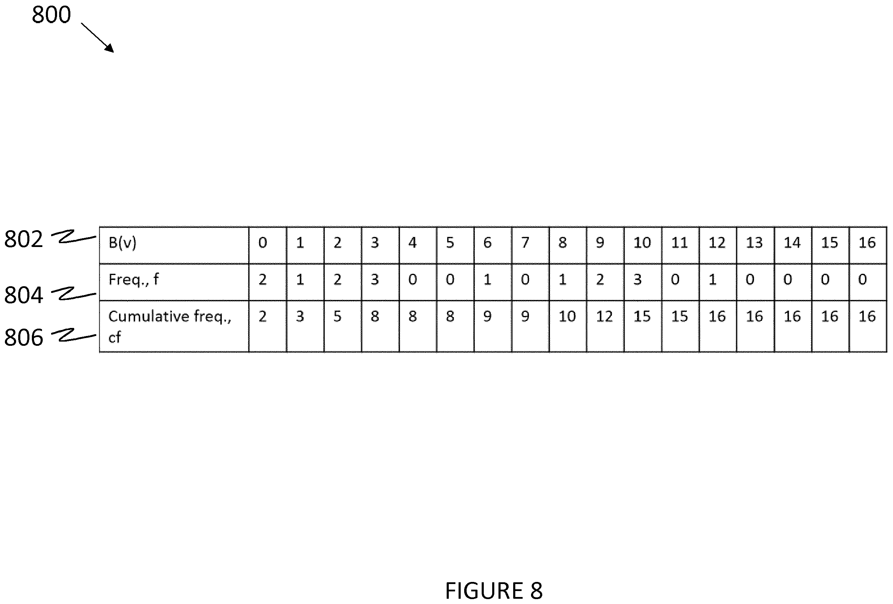

As described at step S112C of process S100C, for each sample in the group of 16 samples determined at step S110C, a cumulative histogram function B(v) is applied. The cumulative histogram function bins the values in order to calculate the number of bits to encode each value as an unsigned integer. This is shown at the second column 604 of the fourth row 614 of the table 600. For example, the value 3133 is described with 12 bits, the value 223 is described with 8 bits. A histogram 800 is generated and an exemplary histogram using the data described with reference to table 600 is shown at Figure 8.

Figure 8 shows a histogram table 800 having three rows 802, 804, 806. The first row 802 shows the number of bits required to describe an unsigned integer. The second row 804 shows the frequency bins corresponding to the number of bits required to describe a difference value as shown at the second column 604 of the third tow 612 of table 600. The third row 806 shows the cumulative frequency bins that show the cumulative frequency of values which are described by the number of bits shown in the first row 802, as the table is sequentially processed from 0 to 16 bits.

Once the process has provided a histogram 800 at step S112C, in accordance with step S114C of process S100C, values that have been placed in the histogram using the cumulative histogram function B(v) are split into two groups. The split point that is used to split the values into two groups is determined by the preferred size of the small and large sets. For a group of 16 values, if 8 values in each group is required, a threshold of 8 is set and the cumulative frequency bins are sequentially assessed until the first bin that takes the cumulative total of samples to equal or greater than the threshold. Once the 16 values have been split into two sets, the bit size of the largest value in each set is determined. In the example of Figure 6, the split point is determined so that the threshold is eight. Accordingly, moving left to right through the cumulative frequency bins of the third row 802 of the histogram table 800, the first bin that is found to be equal to the threshold, or greater, is found. In this example, the threshold value of 8 corresponds to B(v)=3. Therefore the small set can be encoded using a 3 bit unsigned integer, s0=3. Moving right to left through the frequency bins of the second row 804 of the histogram 800, the first bin that contains a non-zero sample is found. In this example, this is the column where B(v)=12. Therefore, the large set can be encoded by a 12 bit unsigned integer, s1=12.

A classifier is also generated as per step S120C of the flow process S100C. The classifier is a mask that is used to classify the originally determined differences of the received data samples as belonging to the smaller set of eight samples, or the large set of eight samples. In this case, 0 represents the smaller set and 1 represents the larger set. Hence the mask 0x07e3 (=0000 0111 1110 0011) is generated, thereby enabling classification of the data differences shown at the second row 610 of the second column 604 of the table 600 into the smaller or larger set. The mask is 16 bits in size, as described at the third column 606 of the fifth row 616 of the table 600. As described above, alternatively, or additionally, any classifier is used to classify the original data sample as belonging to the small set of data values, or the large set of data values. Alternatively, or additionally, a classifier is used to classify the original data sample as belonging to different sets of data values. For example, a small set of data values, a medium set of data values and a large set of data values. Alternatively, or additionally, there may be any number of sets of data values that a classifier may be used to classify.

Since the small set of encoded differences can be described using 3 bits, this information is recorded as metadata along with the information that the large set of encoded differences can be described using 12 bits. This is shown at the sixth row 618 of the table 600. This metadata, in an embodiment, is encoded as 0x48 and takes a total of 8 bits to describe, as shown at the third column 606 of the sixth row 618. The metadata may be encoded in other ways known in the art.

The sorted and split data values are then restored to the original order of the sequence of data samples received in the raw data, as per steps S116C and S118C of process flow S100C. This results in a first set of samples as described at the seventh row 620 of the table 600 and a second set of samples as described at the eighth row 622 of the table 600. Therefore, there is a set of the smallest eight values in the order: 3, 0, 5, 7, 7, 0, 1, 3, as described at the second column 604 of the seventh row 620, which has a size of 8 multiplied by 3 bits (24 bits - as described at the third column 606 of the seventh row 620), since the values of data can be described using 3 bits, as this is permits the largest value of the set to be recorded.

There is also a set of the largest eight values in the order: 3133, 233, 44, 728, 692, 849, 329, 267, as described at the second column 604 of the eighth row 622, which has a size of 8 multiplied by 12 bits (96 bits - as described at the third column 406 of the eighth row 422), since the values of data can be described using 12 bits, as this permits the largest value of the set to be recorded.

In line with step S122C of the process flow S100C, the data that is emitted is shown at the ninth row 624 of the second column 604 of the table 600. The encoded data includes the mask, the metadata and the two sets of re-ordered data and hence has a size of 16 bits for the mask, 8 bits for the metadata, 24 bits for the small set of data and 96 bits for the large set of data. In total, the size of the compressed, encoded data is 144 bits. This is smaller than the original 192 bits determined in respect of the differences between samples of data in a sequence of 16 data samples, but contains enough information for the original data to be decoded. Therefore, in this case, the data stored, once compressed is 75% of the original data size. Whilst compression is described with respect to a particular data set at Figure 6, the process is applicable to different sets of data.

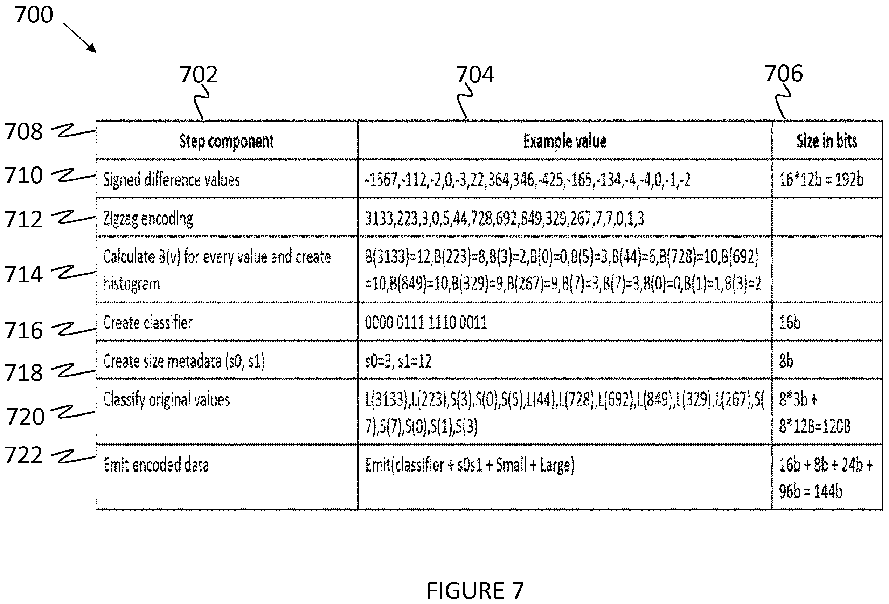

A further worked example of encoding of raw data is shown at Figure 7. Figure 7 is a table 700 illustrating the component stages 702 of video data compression in terms of exemplary real values 704. The illustrative sample set shows unusually high variance. The corresponding size 706, in bits, of the data is shown at the third column 706 of the table 700. The first row of headers 708 describes the content of the columns 702, 704, 706 of the table 700. The first column lists the component stages 702 of video data compression. The second column shows the values 704 of the data samples as they are processed at various stages of the data encoding.

As described above with reference to the process flow S100D, raw data is captured and processed in batches of 16 data samples. The difference between each data sample in the sequence of 16 data samples is made at step S108D of process flow S100D. This provides a sequence of 16 numbers. An example of such 16 number values is shown at the second row 710, second column 704 of the table 700. These values are: -1567, - 112, -2, 0, -3, 22, 364, 346, -425, -165, -134, -4, -4, 0, -1, -2. Each of the values can be described using 12 bits, hence the total size of this data for 16 samples is 192 bits, as described at the second row 710, third column 706 of the table 700.

These values are then encoded using zigzag encoding, as described at step S110D of process flow S100D. Using this method and applying it to the values of the second row 710 of the second column 704 of the table 700, the following values are produced: 3133, 223, 3, 0, 5, 44, 728, 692, 849, 329, 267, 7, 7, 0, 1, 3. These values are shown at the second column 704 of the third row 712 of the table 700.

As described at step S112D of process S100D, for each sample in the group of 16 samples determined at step S110D, a cumulative histogram function B(v) is applied. The cumulative histogram function bins the values in order to calculate the number of bits to encode each value as an unsigned integer. This is shown at the second column 704 of the fourth row 714 of the table 700. For example, the value 3133 is described with 12 bits, the value 223 is described with 8 bits. A histogram 800 is generated and an exemplary histogram using the data described with reference to table 700 is shown at Figure 8.

Figure 8 shows a histogram table 800 having three rows 802, 804, 806. The first row 802 shows the number of bits required to describe an unsigned integer. The second row 804 shows the frequency bins corresponding to the number of bits required to describe a difference value as shown at the second column 704 of the third row 712 of table 700. The third row 806 shows the cumulative frequency bins that show the cumulative frequency of values which are described by the number of bits shown in the first row 802, as the table is sequentially processed from 0 to 16 bits.

Once the process has provided a histogram 800 at step S112D, in accordance with step S114D of process S100D, values that have been placed in the histogram using the cumulative histogram function B(v) are split into two groups. The split point that is used to split the values into two groups is determined by the preferred size of the small and large sets. For a group of 16 values, if 8 values in each group is required, a threshold of 8 is set and the cumulative frequency bins are sequentially assessed until the first bin that takes the cumulative total of samples to equal or greater than the threshold. Once the 16 values have been split into two sets, the bit size of the largest value in each set is determined. In the example of Figure 7, the split point is determined so that the threshold is eight. Accordingly, moving left to right through the cumulative frequency bins of the third row 802 of the histogram table 800, the first bin that is found to be equal to the threshold, or greater, is found. In this example, the threshold value of 8 corresponds to B(v)=3. Therefore the small set can be encoded using a 3 bit unsigned integer, s0=3. Moving right to left through the frequency bins of the second row 804 of the histogram 800, the first bin that contains a non-zero sample is found. In this example, this is the column where B(v)=12. Therefore, the large set can be encoded by a 12 bit unsigned integer, s1=12.

A classifier is also generated as per step S120D of the flow process S100D. The classifier is a mask that is used to classify the originally determined differences of the received data samples as belonging to the smaller set of eight samples, or the large set of eight samples. In this case, 0 represents the smaller set and 1 represents the larger set. Hence the mask 0x07e3 (=0000 0111 1110 0011) is generated, thereby enabling classification of the data differences shown at the second row 710 of the second column 704 of the table 700 into the smaller or larger set. The mask is 16 bits in size, as described at the third column 706 of the fifth row 716 of the table 700. As described above, alternatively, or additionally, any classifier is used to classify the original data sample as belonging to the small set of data values, or the large set of data values. Alternatively, or additionally, a classifier is used to classify the original data sample as belonging to different sets of data values. For example, a small set of data values, a medium set of data values and a large set of data values. Alternatively, or additionally, there may be any number of sets of data values that a classifier may be used to classify.

Since the small set of encoded differences can be described using 3 bits, this information is recorded as metadata along with the information that the large set of encoded differences can be described using 12 bits. This is shown at the sixth row 718 of the table 700. This metadata, in an embodiment, is encoded as 0x48 and takes a total of 8 bits to describe, as shown at the third column 706 of the sixth row 718. The metadata may be encoded in other ways known in the art.

The sorted and split data values are then restored to the original order of the sequence of data samples received in the raw data, as per steps S116D of process flow S100D. This results in a set of samples as described at the seventh row 720 of the table 700. Therefore, there is an interleaved set of the sixteen large and small values in the order: 3133,223,3,0,5,44,728,692,849,329,267,7,7,0,1,3, as described at the second column 504 of the seventh row 520, which has a size of 8 multiplied by 3 bits plus 8 multiplied by 12 bits (120 bits, as described at the third column 706 of the seventh row 720). Since the small values of data can be described using 3 bits, this is permits the largest value of the small values to be recorded and since the large values of data can be described using 12 bits, this permits the largest value of the large set to be recorded.

In line with step S120D of the process flow S100D, the data that is emitted is shown at the eighth row 722 of the second column 704 of the table 700. The encoded data includes the mask, the metadata and the interleaved small and large values and hence has a size of 16 bits for the mask, 8 bits for the metadata, 120 bits for the interleaved small and large values of data. In total, the size of the compressed, encoded data is 144 bits. This is smaller than the original 192 bits determined in respect of the differences between samples of data in a sequence of 16 data samples, but contains enough information for the original data to be decoded. Therefore, in this case, the data stored, once compressed is 75% of the original data size. Whilst compression is described with respect to a particular data set at Figure 7, the process is applicable to different sets of data.

The compression ratio using the method described herein varies depending on the particular video data that has been encoded. Typically, the storage size of an ARRIRAW image is of the order of 50%-60% of the original size, but, beneficially, the data is encoded/decoded at a significantly faster rate compared with known lossless compression techniques, such as lossless JPEG2000. For example, a 16 core (32 virtual core) machine can achieve real time compression of 6560 by 3100 pixels at a rate of 24fps for ARRIRAW data captured with an Alexa65 camera. The benefits of this system also apply to data captured using other systems. Regardless of how variable the video image data that is captured, for real-world images, experiment shows that there is always some compression using the method described herein, which, over the course of a film, provides significant storage saving.

Advantageously, the processes described in respect of S100A, S100B, S100C, S100D and S200 can be performed in any combination of software and/or hardware, thereby providing design flexibility and efficiencies.

Whilst the methods described herein describe the classification of values of a stream of data, such as data sourced from a stream of ordered samples from an image raster, by the use of sorting and histogram binning, other methods of classifying data values such that there the data is described by different bit sizes can be used, thereby to enable encoding of a stream of data and hence provide lossless compression

Beneficially, when the data is compressed using the method described at process flow S100A and S100C, the original data is scrambled, thereby providing a form of obfuscated data that can only be decoded when the necessary information (e.g., the classifier, which may be a mask, such as a bit-mask) is supplied. This property can be exploited to ensure that the data is only decoded by authorised users.

Advantageously, the method described herein enables real-time encoding and therefore can be used to encode data using hardware that forms part of a video camera. Beneficially, lossless data compression is provided at the source as the process can be implemented with a reduction in processing power requirements in comparison with known methods for lossless data compression. Alternatively, or additionally, encoding can be performed remotely from the camera which beneficially defers the need to perform processing of data in real-time and enables post-processing of data as required.

Beneficially, since the data emitted using the method described herein is done so in whole bytes, encoding/decoding complexity is reduced.

Further, beneficially, the use of 16 data samples in a group enables known optimal sorting networks to be used, thereby to provide efficient sorting. Alternatively, or additionally, sample groups of different size are used. Advantageously, larger groups require fewer header blocks to describe the same amount of data.

Advantageously, the method of encoding for lossless compression, described herein, can be implemented on hardware, such as a video camera, without requiring the high powered processing that is conventionally required to provide lossless compression of high density data. As the method provides a degree of compression, even for high complexity video images, over the course of a film there are significant space savings. Beneficially, data can be compressed at the source, i.e., at the video camera, before being distributed as necessary (for example by copying the compressed data for decoding at an end-user, or for streaming compressed data to a remote device).

Further, advantageously, when the method of lossless compression described herein is implemented in hardware, such as in a video camera, this results in a prolonged life of the recording media, as well as increased record times.

Furthermore, beneficially, when data is compressed using the method described herein for storage using LTO cartridges or HDD or SDD storage devices, there is increased speed in respect of Write/Verify/Read. Additionally, when recording compressed data to such devices, the storage requirements are reduced, meaning that fewer tape changes are required when archiving video data and the total number of required storage devices is also reduced.

### Numbered aspects of the invention are as follows:

1. A computer implemented method of encoding a stream of data samples for lossless compression, the method comprising:
   receiving a plurality of data samples in a first order;
   processing the plurality of data samples to provide a plurality of values;
   classifying the plurality of values into a plurality of sets, wherein at least two of the sets of the plurality of sets are classified using different bit sizes;
   generating a classifier indicating the set classification of each value of the plurality of values;
   determining metadata associated with the plurality of sets classified using different bit sizes, wherein the metadata comprises information indicative of the bit size of each of the plurality of values; and
   encoding at least one set of the plurality of sets, the classifier and metadata, thereby to provide lossless compression of the stream of data samples.
2. The computer implemented method of 1, wherein processing the plurality of data samples to provide a plurality of values comprises using a predictor function, preferably wherein the predictor function is used to determine the plurality of values based on temporally earlier and/or spatially local samples of the plurality of data samples.
3. The computer implemented method of 2, wherein the predictor function is an arithmetic difference function, adapted to:
   determine the arithmetic difference between each data sample of the plurality of data samples and a reference sample, wherein processing the plurality of data samples to provide a plurality of values comprises determining the difference between each data sample and a reference sample.
4. The computer implemented method of 3, wherein each data sample of the plurality of data samples has its own reference sample.
5. The computer implemented method of any of 3 or 4, wherein there is one or more global reference samples.
6. The computer implemented method of 4, wherein the reference sample is the immediate predecessor sample for each data sample.
7. The computer implemented method of any of 1 to 6, wherein classifying the plurality of values into a plurality of sets comprises reordering the plurality of values.
8. The computer implemented method of 7, comprising reordering the plurality of values in each of the plurality of sets in accordance with the first order thereby to provide a plurality of reordered sets classified using different bit sizes and wherein the plurality of reordered sets classified using different bit sizes, the classifier and metadata associated with each of the plurality of reordered sets are encoded.
9. The computer implemented method of 7 or 8, wherein reordering the plurality of values comprises applying a sorting function to the plurality of data samples in the first order.
10. The computer implemented method of 9, wherein the sorting function is performed using a sorting network.
11. The computer implemented method of any of 1 to 6, wherein classifying the plurality of values into a plurality of sets comprises using a histogram binning of the plurality of values.
12. The computer implemented method of any of 1 to 11, wherein the plurality of sets comprises a high bit set and a low bit set.
13. The computer implemented method of any 1 to 12, wherein the plurality of data samples consists of sixteen samples and/or wherein the plurality of sets consists of eight samples.
14. The computer implemented method of any of 1 to 13, wherein the plurality of sets are encoded using a compact binary encoding of real integer values.
15. The computer implemented method of 14, wherein the compact binary encoding is a Zigzag encoding.
16. The computer implemented method of any of 1 to 15, wherein the classifier is a bit mask.
17. The computer implemented method of any 1 to 16 where the stream of data samples represents an ordered list of samples from an image raster.
18. The computer implemented method of 17, wherein each data sample of the plurality of data samples corresponds to a signal at an imaging sensor photosite.
19. The computer implemented method of 17, wherein the plurality of data samples in the first order forms part of a scan line captured at a camera.
20. The computer implemented method of 17, wherein the plurality of data samples in the first order corresponds to a colour channel.
21. The computer implemented method of 17, wherein the plurality of data samples in the first order are odd or even sample sequences.
22. The computer implemented method of any of 1 to 21, comprising transmitting the encoded at least one set of the plurality of sets, classifier and metadata.
23. The computer implemented method of any of 1 to 22, wherein the stream of data samples is one or more of video data and audio data.
24. An apparatus arranged to perform the method of any of 1 to 23.
25. The apparatus of 24, wherein the apparatus is arranged to perform the method of any of 1 to 23 in real-time, thereby to record a compressed video data stream.
26. The apparatus according to 24 or 25, wherein the apparatus comprises a video camera.
27. A computer program product comprising instructions which, when the program is executed by a computer, cause the computer to carry out the method of any of 1 to 23.
28. A computer readable medium comprising instructions which, when executed by a computer, cause the computer to carry out the method of any of 1 to 23.
29. A computer implemented method of decoding data, comprising:
   receiving at least one encoded set of data samples, wherein at least two of the encoded data samples of the at least one encoded set of data samples are encoded using different bit sizes;
   receiving a classifier indicating the bit size encoding of each data sample in the at least one encoded set of data samples;
   receiving metadata associated with the at least one encoded set of data samples; and
   decoding the at least one encoded set of data samples in order to retrieve the data samples in their original order based on the classifier and the metadata.
30. An apparatus arranged to perform the method of 29.

## Claims

1. A computer implemented method of encoding a stream of data samples for lossless compression, the method comprising:
receiving a plurality of data samples in a first order;
processing the plurality of data samples to provide a plurality of values;
classifying the plurality of values into a plurality of sets, wherein at least two of the sets of the plurality of sets are classified using different bit sizes;
generating a classifier indicating the set classification of each value of the plurality of values;
determining metadata associated with the plurality of sets classified using different bit sizes, wherein the metadata comprises information indicative of the bit size of each of the plurality of values; and
encoding at least one set of the plurality of sets, the classifier and metadata, thereby to provide lossless compression of the stream of data samples.

2. The computer implemented method of claim 1, wherein processing the plurality of data samples to provide a plurality of values comprises using a predictor function, preferably wherein the predictor function is used to determine the plurality of values based on temporally earlier and/or spatially local samples of the plurality of data samples.

3. The computer implemented method of claim 2, wherein the predictor function is an arithmetic difference function, adapted to:
determine the arithmetic difference between each data sample of the plurality of data samples and a reference sample, wherein processing the plurality of data samples to provide a plurality of values comprises determining the difference between each data sample and a reference sample.

4. The computer implemented method of claim 3, wherein each data sample of the plurality of data samples has its own reference sample; and wherein there is one or more global reference samples or the reference sample is the immediate predecessor sample for each data sample

5. The computer implemented method of any preceding claim, wherein classifying the plurality of values into a plurality of sets comprises reordering the plurality of values in each of the plurality of sets in accordance with the first order thereby to provide a plurality of reordered sets classified using different bit sizes and wherein the plurality of reordered sets classified using different bit sizes, the classifier and metadata associated with each of the plurality of reordered sets are encoded.

6. The computer implemented method of claim 5, wherein reordering the plurality of values comprises applying a sorting function to the plurality of data samples in the first order, wherein the sorting function is performed using a sorting network.

7. The computer implemented method of any of claims 1 to 4, wherein classifying the plurality of values into a plurality of sets comprises using a histogram binning of the plurality of values.

8. The computer implemented method of any preceding claim, wherein the plurality of sets comprises a high bit set and a low bit set.

9. The computer implemented method of any preceding claim wherein the plurality of data samples consists of sixteen samples and/or wherein the plurality of sets consists of eight samples.

10. The computer implemented method of any preceding claim, wherein the plurality of sets are encoded using a compact binary encoding of real integer values, wherein the compact binary encoding is a Zigzag encoding.

11. The computer implemented method of any preceding claim where the stream of data samples represents an ordered list of samples from an image raster, wherein each data sample of the plurality of data samples corresponds to a signal at an imaging sensor photosite, or wherein the plurality of data samples in the first order forms part of a scan line captured at a camera, or wherein the plurality of data samples in the first order corresponds to a colour channel, or wherein the plurality of data samples in the first order are odd or even sample sequences.

12. An apparatus arranged to perform the method of any of claims 1 to 11.

13. A computer readable medium comprising instructions which, when executed by a computer, cause the computer to carry out the method of any of claims 1 to 11.

14. A computer implemented method of decoding data, comprising:
receiving at least one encoded set of data samples, wherein at least two of the encoded data samples of the at least one encoded set of data samples are encoded using different bit sizes;
receiving a classifier indicating the bit size encoding of each data sample in the at least one encoded set of data samples;
receiving metadata associated with the at least one encoded set of data samples; and
decoding the at least one encoded set of data samples in order to retrieve the data samples in their original order based on the classifier and the metadata.

15. An apparatus arranged to perform the method of claim 14.
